(19) **Europäisches Patentamt**

**European Patent Office**

**Office européen des brevets**

(11) **EP 1 174 009 B1**

(12) **EUROPEAN PATENT SPECIFICATION**

(45) Date of publication and mention
of the grant of the patent:
**16.10.2002 Bulletin 2002/42**

(51) Int Cl.⁷: **H05K 7/20**

(21) Application number: **00908183.7**

(86) International application number:
**PCT/SE00/00273**

(22) Date of filing: **11.02.2000**

(87) International publication number:
**WO 00/059280 (05.10.2000 Gazette 2000/40)**

(54) **ENCLOSURE FOR ELECTRIC EQUIPMENT**

GEHÄUSE FÜR EINE ELEKTRISCHE ANLAGE

ENVELOPPE POUR EQUIPEMENT ELECTRIQUE

(84) Designated Contracting States:
**AT BE CH CY DE DK ES FI FR GB GR IE IT LI LU MC NL PT SE**

(30) Priority: **29.03.1999 SE 9901128**

(43) Date of publication of application:
**23.01.2002 Bulletin 2002/04**

(73) Proprietor: **Bombardier Transportation GmbH
13627 Berlin (DE)**

(72) Inventor: **ERIKSSON, Gunno
S-734 33 Hallstahammar (SE)**

(74) Representative: **Cohausz & Florack
Patentanwälte
Kanzlerstrasse 8a
40472 Düsseldorf (DE)**

(56) References cited:
**DE-A1- 4 313 782        DE-A1- 19 545 448
DE-A1- 19 734 270        SE-B- 455 242
US-A- 5 305 185          US-A- 5 323 295**

## Description

TECHNICAL FIELD

The present invention relates to an air-tight enclosure for protecting electric equipment against dirt and moisture. The enclosure is designed to facilitate giving off heat from the equipment. Preferably, the invention relates to cooling of, for example, static converters or thyristors which are mounted on the outside of rail-mounted vehicles and which are enclosed to be protected from the surrounding environment.

BACKGROUND ART

Prior art enclosures comprise profiled walls with a base plate with both internally and externally projecting heat-conducting members. The heat is conducted via the internal heat-conducting members to the base plate and from the base plate to the external heat-conducting members. The projecting members increase the convection since heated air flows along the heat-conducting members and is replaced by colder air. An enclosure manufactured from this type of profiles, however, does not give optimum cooling capacity when the surrounding medium has a high velocity since the heat is conducted over a long distance from an internal member to the centre web and out into an external member.

DE-A-19734270 discloses an air cooled power converter wherein the heat conducting members are parallel each with respect to the other and do not form therefore any partition wall with a wave-like cross section.

SUMMARY OF THE INVENTION

To protect electric equipment in exposed environments from harmful influence, the equipment is enclosed into closed cubicles or boxes. The enclosure is filled with air or with another gas. The invention relates particularly to enclosure of such electronic equipment which is mounted on the outside of rail-mounted vehicles. This equipment is often mounted on the underside of the train. There, the enclosure must be able to withstand snow, ice, dirt, wet, moisture and mechanical influence, for example from stones and gravel splashing up from the railway embankment. Heat from the equipment is carried off with the aid of cooling units and/or fans inside the enclosure. The lower temperature of the surroundings and the convection provided by the airstream are also utilized.

The total heat transport from the electric equipment to the air surrounding the enclosure may, in simple terms, be said to consist of the heat transfer from the gaseous medium to the inner surface of the enclosure, the thermal conduction through the enclosure itself, and the heat transfer from the outer surface of the enclosure to the surrounding air.

Different phenomena are limiting for the efficiency of the cooling in the case of natural and forced convection. For an enclosure where the surrounding air is relatively stationary, the thermal conduction through the material is relatively insignificant compared with the heat transfer between the surface of the enclosure and the surrounding air. One way of improving the cooling is to increase the surface of the enclosure.

The heat transfer from a surface to a surrounding fluid is described by the empirical relationship

$$\dot{Q}_1 = hA(T_b - T_f)$$

where $\dot{Q}_1$ is the heat flow, h is the heat transfer coefficient, a parameter which is dependent on the convection and the shape of the surface, A is the area, Tb is the temperature of the surface, and Tf is the temperature of the surroundings.

With increased convection, the heat transfer coefficient h increases, but the difference in temperature between the surface and the surroundings (Tb-Tf) decreases. At high convection, thus, the heat transfer from the surface is less than at natural convection.

For an enclosure mounted on the outside of a vehicle where the surrounding air moves with the speed of the vehicle, the thermal conduction through the enclosure itself is more important for the efficiency of the cooling than for an enclosure in stationary air, since the contribution of the thermal conduction to the total heat transport is relatively greater.

According to Fourier's law for thermal conduction, the heat flow is proportional to the area and the temperature gradient. By designing the enclosure such that the heat is conducted a short distance to obtain a great temperature gradient while at the same time the area is large, efficient heat conduction is obtained:

$$\dot{Q}_x = -\kappa A \frac{dT}{dx}$$

where $\dot{Q}_x$ is the heat flow, $\kappa$ is the thermal conductivity: a material constant, A is the area, T is the temperature, and x is a distance perpendicular to the area.

It is desirable to make use of an enclosure which has a large surface but which also has thin walls to limit the thermal resistance through the wall. It is especially suitable that the enclosure comprises profiled walls with a wave-like cross section. This causes the surface which gives off heat to be large while at the same time the distance, over which the heat is conducted, is small.

BRIEF DESCRIPTION OF THE DRAWINGS

The invention will be explained by description of embodiments with reference to the accompanying drawings, wherein

Figure 1 shows a cross section of part of the wall of the enclosure with a base plate and heat-conducting members, projecting therefrom, according to the prior art.

Figure 2 shows a cross section of part of the wall of the enclosure according to the invention, with a wave-like cross section.

## DESCRIPTION OF THE PREFERRED EMBODIMENTS

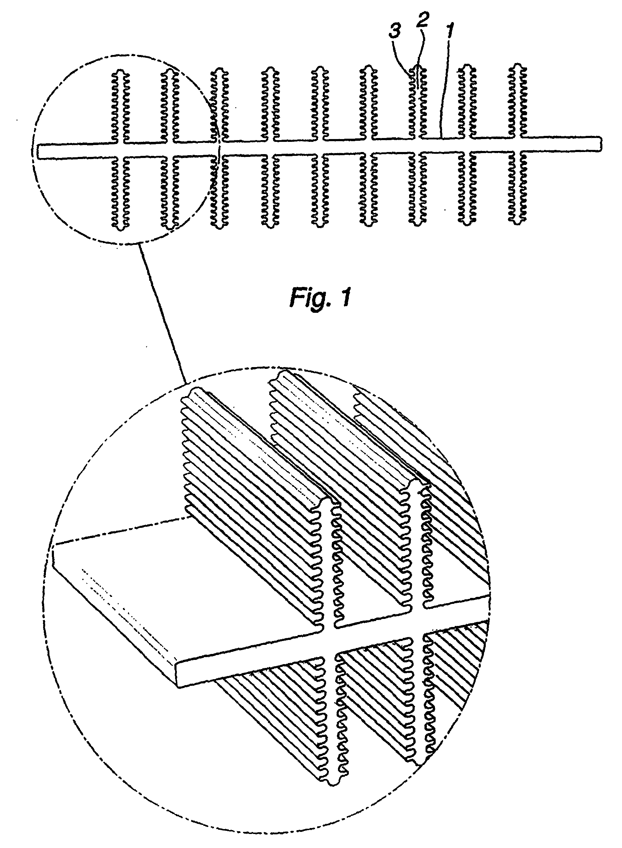

**Figure 1** shows a cross section of part of an enclosure according to the prior art; a profiled wall cooling with a base plate 1 and heat-conducting members 2, projecting internally and externally from the base plate. The enclosure is intended to be used for electric equipment which is mounted under a train. The wall has been designed to obtain a large surface for giving off heat. The heat-conducting members are designed as flanges with longitudinal ridges 3. On the inside of the enclosure, a fan and/or a cooling unit, not shown, are placed to obtain efficient cooling by increased convection. On the outside of the enclosure, the airstream gives a very high convection and hence good cooling.

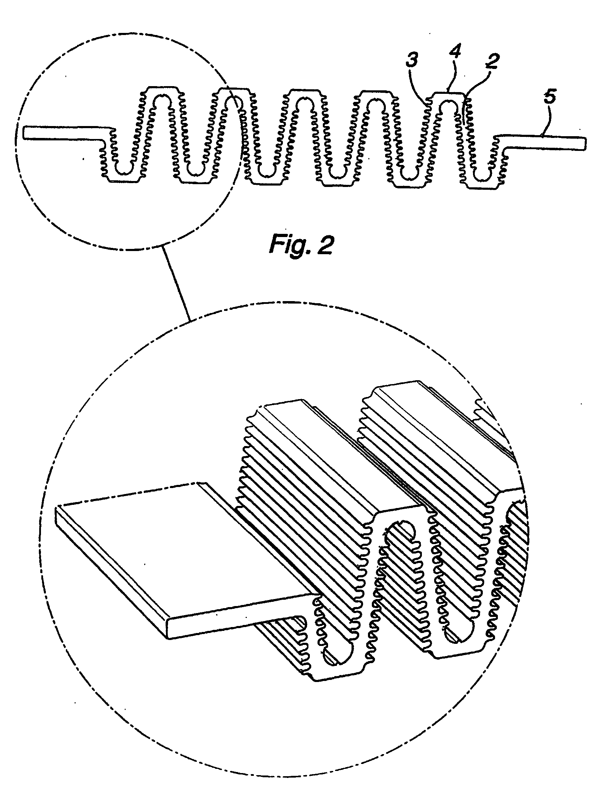

**Figure 2** shows a cross section of part of an enclosure according to the invention. With this design of the enclosure, in addition to a large surface, also a small distance between the inside of the profile and the outside of the profile is obtained. To obtain a large surface which takes up and gives off heat, the heat-conducting members 2 are arranged at an angle to one another so as to form a wave-like wall. According to this embodiment, the heat-conducting members are provided with longitudinal ridges 3. The heat-conducting members are connected to plane portions 4 and have an outer edge 5 to facilitate mounting and handling.

A comparative experiment between an enclosure according to the invention and an enclosure according to the prior art shows that the enclosure according to the invention provides improved cooling capacity at natural convection. At forced convection, the cooling capacity is considerably better. A partition with a wave-like cross section according to the invention carries off heat 3-4 times more efficiently, when the surrounding air moves at 8 m/s, than a profile with a base plate and protruding heat-conducting members. Typical air velocities around a train in motion are 12-20 m/s. At such velocities, an enclosure with a wave-like partition is even more efficient.

The enclosure according to the invention is dimensioned according to a specific cooling requirement, whereby an enclosure with a lower weight is obtained, which occupies less space and requires less material compared with an enclosure, dimensioned according to the same criteria, in accordance with the prior art.

The material in a cooling profile should have a high thermal conductivity. Examples of such materials are copper and aluminium and alloys of these materials.

Aluminium may advantageously be extruded, with a good result, into profiles which are rich in details. Cooling profiles shall have a large surface and therefore extrusion is a suitable manufacturing method. Ridges and grooves and other structural elements, which give a large surface, may be achieved.

The gaseous medium which is enclosed in the enclosure, and which surrounds the electric equipment, is normally air but may be replaced by another gas having properties which are suitable for each individual purpose.

## Claims

1. An air-tight enclosure, surrounding electric equipment, arranged on the outside of a rail-mounted vehicle, for carrying off heat from the electric equipment, the limiting surface of which comprises a plurality of heat-conducting members (2), **characterized in that** the heat-conducting members separate the air, contained in the enclosure, from surrounding air and that they form a coherent partition with a wave-like cross section.

2. An enclosure according to claim 1 **characterized in that** the plane of extension of the members form an angle with each other.

3. An enclosure according to claim 1, **characterized in that** the partition exhibits the shape of a sine wave.

4. An enclosure according to any of the preceding claims, **characterized in that** the heat-conducting members are arranged with longitudinal ridges (3).

5. An enclosure according to any of the preceding claims, **characterized in that** the heat-conducting members are interconnected by plane outer portions (4).

6. An enclosure according to any of claims 1-5, **characterized in that** the partition is made of extruded aluminium.

7. An enclosure according to any of claims 1-5, **characterized in that** the partition is made of corrugated sheet.

8. A method for carrying off heat from electric equipment, which is arranged in an enclosure and surrounded by an enclosed gaseous medium, into the surrounding air, wherein the enclosure is brought to comprise a plurality of heat-conducting members, **characterized in that** the heat-conducting members are arranged to separate the gaseous medium, contained in the enclosure, and the surrounding air, and that the heat-conducting members are arranged at an angle to one another so as to form a wave-like wall.

9. A method according to claim 8, **characterized in that** the heat-conducting members are provided with longitudinal ridges (3).

## Patentansprüche

1. Luftdichtes Gehäuse, welches ein elektrisches Gerät umschließt und zur Wärmeabfuhr des elektrischen Gerätes an der Außenseite eines schienengebundenen Fahrzeuges angeordnet ist, und dessen Grenzfläche eine Vielzahl von Wärmeleitelementen (2) umfasst, **dadurch gekennzeichnet, dass** die Wärmeleitelemente die im Gehäuse enthaltene Luft von der Umgebungsluft trennen und dass sie eine zusammenhängende Trennwand mit wellenartigem Querschnitt bilden.

2. Gehäuse nach Anspruch 1, **dadurch gekennzeichnet, dass** die Flächen der Erstreckung der Elemente einen Winkel miteinander bilden.

3. Gehäuse nach Anspruch 1, **dadurch gekennzeichnet, dass** die Trennwand die Form einer Sinuswelle aufweist.

4. Gehäuse nach einem der vorangehenden Ansprüche, **dadurch gekennzeichnet, dass** an den Wärmeleitelementen Längsrippen (3) angeordnet sind.

5. Gehäuse nach einem der vorangehenden Ansprüche, **dadurch gekennzeichnet, dass** die Wärmeleitelemente durch flache Außenabschnitte (4) verbunden sind.

6. Gehäuse nach einem der Ansprüche 1-5, **dadurch gekennzeichnet, dass** die Trennwand aus extrudiertem Aluminium hergestellt ist.

7. Gehäuse nach einem der Ansprüche 1-5, **dadurch gekennzeichnet, dass** die Trennwand aus Wellblech hergestellt ist.

8. Verfahren zum Abführen von Wärme von einem elektrischen Gerät, welches in einem Gehäuse angeordnet und von einem gasförmigen Medium umschlossen ist, in die Umgebungsluft, wobei das Gehäuse mit einer Anzahl von Wärmeleitelementen versehen ist, **dadurch gekennzeichnet, dass** die Wärmeleitelemente angeordnet sind, um das im Gehäuse enthaltene gasförmige Medium und die Umgebungsluft zu trennen, und dass die Wärmeleitelemente in einem Winkel zueinander angeordnet sind, um eine wellenförmige Wand zu bilden.

9. Verfahren nach Anspruch 8, **dadurch gekennzeichnet, dass** die Wärmeleitelemente mit Längsrippen (3) versehen sind.

## Revendications

1. Enceinte étanche à l'air, entourant equipement électrique, disposée sur l'extérieur d'un véhicule monté sur rail, en vue d'emmener de la chaleur de l'équipement électrique, dont la surface limite comprend une pluralité d'éléments (2) conduisant la chaleur, **caractérisée en ce que** les éléments conduisant la chaleur séparent l'air, contenu dans l'enceinte, de l'air environnant et **en ce qu'**ils forment une cloison cohérente avec une section transversale analogue à une onde.

2. Enceinte selon la revendication 1, **caractérisée en ce que** le plan d'extension des éléments forme un angle, l'un avec l'autre.

3. Enceinte selon la revendication 1, **caractérisée en ce que** la cloison présente la forme d'une onde sinusoïdale.

4. Enceinte selon l'une quelconque des revendications précédentes, **caractérisée en ce que** les éléments conduisant la chaleur sont disposés avec des arêtes longitudinales (3).

5. Enceinte selon l'une quelconque des revendications précédentes, **caractérisée en ce que** les éléments conduisant la chaleur sont reliés entre eux par des parties externes planes (4).

6. Enceinte selon l'une quelconque des revendications 1 à 5, **caractérisée en ce que** la cloison est fabriquée en aluminium extrudé.

7. Enceinte selon l'une quelconque des revendications 1 à 5, **caractérisée en ce que** la cloison est fabriquée en tôle ondulée.

8. Procédé pour emmener de la chaleur d'un équipement électrique qui est disposé dans une enceinte et entouré par un milieu gazeux clos, dans l'air environnant, dans lequel l'enceinte est amenée à comprendre une pluralité d'éléments conduisant la chaleur, **caractérisé en ce que** les éléments conduisant la chaleur sont disposés de sorte à séparer le milieu gazeux, contenu dans l'enceinte, et l'air environnant, et **en ce que** les éléments conduisant la chaleur sont disposés selon un angle, l'un par rapport à l'autre, en vue de former une paroi analogue à une onde.

9. Procédé selon la revendication 8, **caractérisé en**

**ce que** les éléments conduisant la chaleur sont pourvus d'arêtes longitudinales (3).

Fig. 1

Fig. 2